# EUROPEAN PATENT APPLICATION

(11) **EP 2 669 172 A1**
(43) Date of publication of application: **04.12.2013**
(21) Application number: 12170440.7
(22) Date of filing: 01.06.2012
(51) Int. Cl.: B63B 9/00

(54) **Method and system for predicting the performance of a ship**

(71) Applicant: ABB Technology AG, 8050 Zürich (CH)
(72) Inventor: Tervo, Kalevi, 00980 Helsinki (FI)
(74) Representative: Söderman, Lisbeth Karin

(57) **Abstract**

The invention is concerned with a computer-implemented method to produce a model that predicts the performance of a ship. The method comprises the steps of creating an initial model for simulating the performance of the ship by means of relationships between factors related to the ship during operation and parameters presenting primary dynamic input data that depend said factors depend on. Measurement results are obtained from sensors during the operation of the ship for producing a set of new dynamic input data to be used in the model. A simulation result for the ship performance is calculated by using said produced input data in said model instead of the primary dynamic input data. The simulation result is then compared to the actual ship operation. If the difference between the simulation result and the actual operation exceeds defined threshold criteria, the model is improved by repeatedly producing new sets of dynamic input data to be used in the model by means of new measurement results until defined quality criteria are met. The invention is also concerned with a system and that performs such a method and a computer program.

## Description

### TECHNICAL FIELD

The invention is concerned with a method and system and a computer program for predicting the performance of a ship.

### BACKGROUND

In a seagoing vessel, fuel, like oil or sometimes natural gas, is used as an energy source and a diesel engine is used as a main engine. In a large marine vessel, there may be several diesel engines that rotate generators or main propellers of the vessel. The fuel is delivered to the marine vessel in the harbors or during the voyage by fuel tankers. There might also be different kinds of fuels available and several diesel engines that are driven in parallel and simultaneously.

The power production and propulsion system has been targets for continuous adjustment, control and monitoring in order to achieve optimal efficiency. The power control is a fundamental part of the control system of a ship. Likewise, the propulsion system is controlled to produce the required power by using the available electric and/or primary energy. In practice, however, the sufficiency of energy has not been as critical as the efficiency of the devices and their control systems.

By controlling the power of the separate devices on board, energy can be consumed efficiently and economically. This applies e.g. for individual propulsion units, pumping devices, lighting and heating equipments and other auxiliary devices.

All these factors related to different fuels and devices, inclusive the price, quality and availability of the fuel affect the overall energy efficiency of the marine vessel and should be taken into consideration in the optimization and configuration of the power plant of the ship.

Current solutions for dynamic optimization of trim and power plant configuration on vessels are usually based on models that require human supervision at various stages or rely on models that are based on design data or other such design related static information. In addition, such optimization models currently require initial modelling (either hydrodynamic or numerical) as well as calibration or re-modelling, when the hull/propeller ages or its resistance changes. The reliability of the models thus degrades over a period of time after which they are not useful for its purpose of saving costs anymore.

An example of a solution for efficient energy control based on design data is presented in WO publication 2011/161211 discloses an example of a method and arrangement for controlling energy consumption in a marine vessel on the basis of different input data, such as operational data, route data, weather forecast and different environmental factors. Also data related to the fuel itself, like fuel type, fuel costs etc. are taken into consideration. The energy balance of the energy consuming devices is managed on the basis of a calculated prediction that is based on said input data.

WO publication 2007/017908 presents a design tool to increase the efficiency of ship design by making it possible for designers to employ tools that assist in the design of ships. The design tool is also used to optimize the operational cost of the ship in operation by receiving signals from sensors and simulating the operation according to the sensor information and adjust the energy system accordingly. The publication is an improvement in view of solutions relying only on design data in that it also takes sensor information into consideration for controlling the energy balance during operation.

The object of the invention is to develop improved methods and systems for creating the simulation models themselves and for using the created models for improving ship performance in order to minimize fuel consumption.

### TERMS USED IN THE APPLICATION

The following terms are used in the application text

TRIM: The floating inclination of the ship in the longitudinal (pitch) direction, i.e. the difference between the sinkage of the fore and aft of the ship.

LIST: The floating inclination of the ship in the transversal (roll) direction.

DRAFT: The midship sinkage of the ship.

FLOATING POSITION: Trim, draft or list or any combination of trim, draft and list. The floating position affects the displacement, wet surface and the water resistance of the ship.

POWER PLANT CONFIGURATION: The sharing/distribution of the load between different power generation and consuming devices (like diesel generators, shaft generators, waste heat recovery systems, etc.).

OPTIMAL POWER PLANT CONFIGURATION: The distribution of load between different power generation and consuming devices that fulfills the optimization criteria such as fuel consumption, emissions, etc.

SHIP BEHAVIOUR/SHIP PERFORMANCE: Describes the actual function of the ship including e.g. the movement, energy consumption, fuel consumption, and emissions of the ship.

SHIP OPERATION: Describes the maneuvering and steering and control actions of the ship in order to drive the engines and electrical devices and move the ship.

VESSEL used synonymously with SHIP

SEA STATE: The state of the sea determined by the wave height, wave period, wave direction, swell, wind-induced waves, etc.

### SUMMARY OF THE INVENTION

The object is achieved by means of a computer-implemented method to produce a model that predicts the performance of a ship. The method comprises the steps of creating an initial model for simulating the performance of the ship by means of relationships between factors related to the ship during operation and parameters presenting primary dynamic input data that depend said factors depend on. Measurement results are obtained from sensors during the operation of the ship for producing a set of new dynamic input data to be used in the model. A simulation result for the ship performance is calculated by using said produced input data in said model instead of the primary dynamic input data. The simulation result is then compared to the actual ship operation. If the difference between the simulation result and the actual operation exceeds defined threshold criteria, the model is improved by repeatedly producing new sets of dynamic input data to be used in the model by means of new measurement results until defined quality criteria are met.

The system of the invention in a ship for predicting the performance of a ship has means to perform the above method. Thus, the system comprises a processor unit having a computer model that simulates the performance of a ship. The model defines relationships between factors relating to the operation of a ship and parameters presenting dynamic input parameters that said factors depend on. The model has means for learning dependencies between the said factors and the dynamic input parameters, means for continuously obtaining measurement results during the operation of the ship and for using the measurement results for producing sets of new dynamic input parameters to be used in the model instead of input parameters used earlier in the initial model, means for calculating a new simulation result for the ship performance by using said produced input data in said model, means for comparing the optimized simulation result with the actual ship operation, and means for updating the initial model to be used as the model in further operation and further updating the model until the model meets preset quality criteria. The system also comprises sensors that give signals of measurement results during the operation of the ship to the processor.

The computer program product of the invention is run in a processor unit in a ship and constitutes a model simulating the performance of a ship. The model defining relationships between factors relating to the performance of a ship and parameters presenting dynamic input parameters that said factors depend on. The program and performs the steps of automatically learning dependencies between said factors and the dynamic input parameters, continuously using sets of new dynamic input parameters in the simulation instead of input parameters used earlier, the new dynamic input parameters being produced from measurement results from sensors during the operation of the ship, and updating itself until it meets preset quality criteria preset quality criteria.

The preferable embodiments of the invention have the characteristics of the sub claims.

The method and system of the invention can e.g. be used for the optimization of the energy production on board or for the optimization of the vessel position, such as the trim, draft or list. In the foregoing case, the model for simulation of the ship performance simulates the fuel consumption, the energy consumption and energy production, and in the latter case it simulates the vessel propulsion energy consumption as a function of the floating position. The trim of a vessel is defined as the difference between the sinkage of bow and stern, the draft as the sinkage of the vessel (in the midship), and the list as the permanent angle of inclination in the transversal direction of the ship.

When the invention is used for the optimization of the energy production, measurements are obtained telling the current situation on board and a power plant configuration with the lowest energy need is found by simulation with the energy optimization simulation model. The power plant configuration can comprise diesel engines, diesel generators, shaft generators), shaft motors, waste heat recovery systems, and machines and generators working with different fuels etc. The power plant configuration in this context refers to the distribution of the load between different power generation devices.

Thus, the model continues improving itself until it meets the predefined completion and quality criteria. The stopping criteria can include e.g. the range of variation of an input signal compared against the expected range of variation of the signal, additional information content of the new input data compared to the data seen previously, the prediction performance of the model, statistical significance of the model parameters, statistical significance of the amount of data, etc. The model also monitors the quality of input data such as it evaluates the reliability of a measurement signals based on the dynamics of the difference between the predicted and measured values, as well as the behavior of the input signals. In addition, the mutual dependencies between the input signals and the output signals can be monitored by the model, and if dependencies between the measured input signals change, the model is able to estimate the quantity based on the measurement history, the current values. In addition to the estimation, once the model has been trained, it is possible to recognize the breakdown of sensors by using the model.

In the quality control, the relation between the measurements, the own dynamic of the measurement and physical variations of the measurements are monitored. This can be exemplifies by means of e.g. the speed of the ship. The ship is a very big entirety and its speed can not change very fast. The model can take impossible changes and changes of no sense or differences defined to be too big into consideration by comparing the speed measurement to the foregoing state of the ship and to other measurements an make a decision if the measurement can be trusted or not. If the measurement can not be trusted the model can decide e.g. to ignore it.

Another example is related to measurement errors. The maximum speed of the ship is known and if a measurement value e.g. exceeds that it can be a physically impossible value and can be deleted from training data. By using the model, these measurements can be ignored or it can be estimated to be some other value on the basis of information and dynamics from other measurements, foregoing values, the relationships describing the measurements.

Models simulating the performance of a ship to be used for the real configuration of the power plant are very complicated since they depend on a lot of factors. Some of the factors can be influenced on since they relate to the devices for operating the ship and are called dynamic factors in this text.

Static factors to be taken into consideration in creating the models may e.g. be related to the construction of the ship and the design and are not changeable during operation anymore.

For example the energy consumption, fuel consumption and energy production, as well as the additional energy consumption due to the vessel floating position, such as the trim, draft or list, of the ship are determined both by static factors and by variable dynamic factors. Some variables may be fixed for a given trip, such as the route and the type and costs of the fuel in which case they are static for that particular trip. Sometimes these variables can change from the initial plan for a given trip.

With respect to dynamic factors they are not simply determined by the design of the ship but is also affected by external conditions during the operation of the ship, such as weather and sea currents, sea depths, speed, emission targets, and operational factors, like the list and modes of operation like harbor operation mode and the use of open operation mode drive or maneuvering operation mode, which have different kind of demands. Further factors include e.g., the route, the speed of the ship, fuel costs, and/or emission values.

In prior art solutions, the energy load balance of the different devices was managed and optimized on the basis of an estimated consumption and by means of simulation models for e.g. an efficient fuel consumption that could predict the need of energy and by means of which the load of individual energy consuming devices were distributed.

This invention provides a self-learning simulation model that improves itself automatically without human interaction during the operation of the ship by making use of sensor information.

In one embodiment, the model continuously updates itself with respect to the relationships between the energy consumption of individual devices and external conditions and learns how given circumstances and the energy load of different devices affect on the total fuel and energy consumption.

In another embodiment, the model continuously updates itself with respect to the relationships between the vessel floating position and external and operational conditions and learns how given circumstances affect on the vessel position, as well as the added resistance and energy consumption due to the changes in the floating position. The model continues improving itself until it meets the predefined completion and quality criteria. The stopping criteria can include e.g. the range of variation of an input signal compared against the expected range of variation of the signal, additional information content of the new input data compared to the data seen previously, the prediction performance of the model, statistical significance of the model parameters, statistical significance of the amount of data, etc.

The model is used for improving the operation of the ship when the model has become good enough, i.e. when it can predict the total energy and fuel consumption or the mutual relationships between the variable dynamic factors more accurately than an existing model. It is taken for use when it meets certain quality criteria that are set for e.g. the allowed difference between the predicted fuel and energy consumption (that is calculated by means of the model by using the measurements as input data) and the actual fuel and energy consumption, which the control unit of the ship is aware of during the entire trip.

The model can then be used to present advice and setpoints for how the power plant configuration should be changed with respect to the distribution of the load of energy or the duration of use of the different energy consuming devices. Alternatively, advice can be given for changing the vessel floating position, such as the trim of the ship.

Thus, the invention provides a method for creating a model that predicts e.g. energy consumption and fuel consumption on the basis of various dynamic input data and continuously improves itself until preset threshold quality criteria are met within a given tolerance by making use of threshold criteria for the model to use for the decision making. In this way, the model performance is periodically rechecked.

The free parameters of the model of the invention are estimated using, or the model can be purely based on, real operational data in contrary to prior art methods which rely on design or theoretical data or mini-scale data. As the model is self-learning, no human interaction is needed for estimating the model for optimization of e.g. the power plant configuration and the trim.

Self improving of the model takes place by checking against above mentioned completion criteria. Also quality checking over long periods of time takes place without human interaction.

The invention provides more accurate fuel saving optimization solutions due to usage of real operational data and simpler fuel saving solutions, which are not so work-intensive, due to the self-learning nature of the model. The change in the model in time domain equals degradation, improvement or maintenance of the system.

Next, the invention is described by means of some illustrative schemes and embodiments to which the invention is not limited.

### FIGURES

Figure 1 presents a first example embodiment of the invention in the form of a block diagram
Figure 2 presents a flow scheme of the first example embodiment of the invention
Figure 3 presents a second example embodiment of the invention in the form of a block diagram
Figure 4 presents a flow scheme of the second example embodiment of the invention

### DETAILED DECSRIPTION

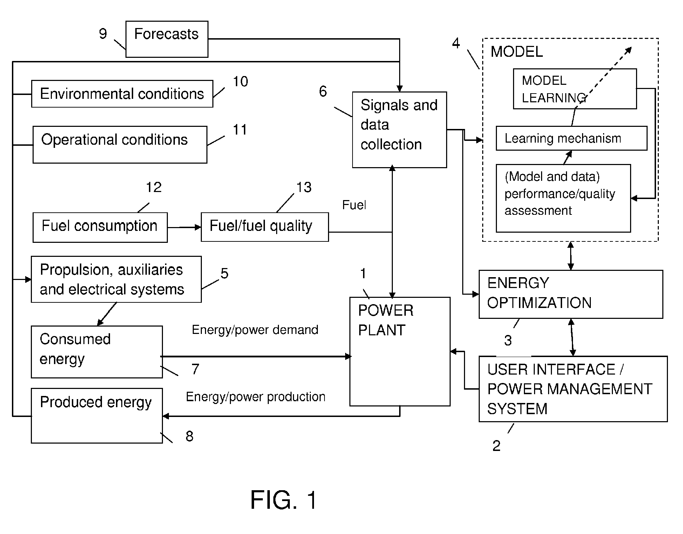

Figure 1 presents a first embodiment of the invention in the form of a block diagram. In this embodiment the invention is used for predicting the energy balance of energy consuming devices on a ship and the fuel consumption, whereby the model simulates the performance of the power plant as a function of the power plant configuration.

Figure 1 illustrates the interactivity between the control system of the ship, the conditions on board, and the energy production and consumption and fuel consumption. The control system includes the model for simulating the performance of the ship and the function of energy optimization, which are used in the invention to improve the model and to determine the most fuel efficient power plant configuration to produce the currently required energy.

Energy consuming devices in the vessel are those relating to propulsion energy, whose duty is to move and guide the vessel from the port of departure to the port of destination. Other energy consuming devices are partially independent of the movement of the vessel, such as auxiliary devices for lighting, pumping, heating, cooling, steam production, and other internal processes for the operation of the ship.

Several factors and parameters related to the energy consumption of a ship are taken into account in the practical operation of the ship as well as in the distribution of the energy load on different engines and auxiliary devices on board.

The energy and fuel consumption are determined both by static factors and variable dynamic parameters. Static parameters may be related to the design of the ship or e.g. a given route.

With respect to dynamic parameters, the energy and fuel consumption is determined not only by the co-action of the different devices but is also affected by external conditions during the operation of the ship, such as weather, wind, sea state, sea currents, sea depths, ambient temperature, ambient humidity, barometric pressure, seawater temperature and by operational parameters, such as use of propulsion and auxiliaries, constraints, speed, emission targets, operating hours, and modes of operation like drive in harbour, open sea drive or maneuvering drive, which have different kind of demands.

In this invention, an initial simulation model is created for simulating the performance of the ship. The model defines relationships between factors related to the ship during operation (such as energy load, fuel consumption and energy distribution) and parameters presenting dynamic input data that said factors depend on. The initial model is improved by a self-learning mechanism in order to define a simulation model to be used during operation of the ship. The initial model can be based on earlier knowledge or then the initial model is directly created on the basis of collected data on board.

The initial model is then implemented to simulate the performance of the power plant in real-time and improve itself until it has become good enough. Once the model meets the predefined quality criteria, it starts providing the user with instructions of how to change the power plant configuration in order to save fuel.

The block diagram of figure 1 consists of blocks that represent machines, sensors, control and management units, and data handling units. The arrows from the blocks describe the output of the blocks and the arrows to the block describe the input of the blocks.

A power plant 1 is installed on the ship to serve as a power generation resource with a generator, that converts mechanical power into electrical power and other possible electricity generation engines, like gas turbines, reciprocating diesel and gas engines, boilers or nuclear reactors. As a side product, the power plant produces thermal energy, which can partially be recovered from the exhaust gas and cooling circuits.

The demand and production of the power/energy as symbolized with reference numbers 7 and 8, respectively, needed to operate the ship are balanced by the power management system 2.

The power plant 1 generates the required power for the need of the vessel and creates the propulsion power for the propellers. Thus, the power plant 1 supplies 7 the energy to the propulsion system and to all the electric power consuming and auxiliary devices that are symbolized as unit 5 in figure 1.

Information from the power plant 1 will be transferred via a signal and data collection function unit 6 to the control unit to get all the basic data from load points to available power in order to find the right energy balance on the system. E.g. the number and the load sharing of the energy production devices are decided in order to produce the required power as efficiently as possible in the power plant configuration.

The control unit includes a model 4 for simulation of the energy and fuel consumption of the ship based on signals received from sensors, an energy optimization unit 3 and a power management system 2.

The power management system 2 of the control unit controls the total power production and delivery of the vessel by means of a power plant configuration, according to which configuration also the distribution of the energy load on different devices are determined.

The power management system 2 of the control unit can also cover additional functions, such as power shedding of consumers (disconnection of a part of distribution because of exceed of available amount of energy) in decision making of starting and stopping of engines and devices.

There is a user interface connected to the power management system 2 by means of which the optimum power plant configuration is shown if it is possible in view of the overall energy balance management. The optimization can if desired take security limits and logical factors into consideration. The power management system 2 has to take care of that there is enough energy available. The optimization system 3 advices the user how the power plant should be operated in the current situation and the user then makes changes in the existing power management system. Alternatively the optimization system 3 can give the optimal configuration directly to the power management system 2 which then automatically takes the required actions.

The control unit can also control the actual load shedding profiles and load shedding of the system. The control unit will also, based on process references received from the power plant configuration, efficiently control the auxiliary consumers connected to the system. The function of energy optimization 3 is performed by a simulation model 4. The simulation model is created on the basis of the fuel and energy consumption and the use of the devices in the power plant and thus describes the amount of fuel needed to produce the needed power/energy with different configurations and settings.

The invention aims at operating the ship by means of an optimal power plant configuration, which is strived to be improved continuously by means of the signals received from sensors and systems and the simulation model that also is continuously improved.

The optimal power plant configuration given by the optimization is based both on forecasts 9 on .e.g. the route, weather, oceanographic, and/or schedule forecasts, and actual environmental conditions 10, like weather, wind, sea state, sea currents, sea depths, ambient temperature, ambient humidity, barometric pressure, and/or seawater temperature. In addition, constraints of operation such as the required spinning power reserve in different operation modes, as well as maintenance, breakdown or other unexpected shutdown of machinery are taken into account.

Route information includes ports data and gives available information about the ports from the start point to the destination and of any intermediate points between these points. The control unit creates a route plan considering input data and calculates the external forces the marine vessel will face during the voyage from the start point to the end point and calculates an estimate for energy and fuel consumption by means of ship performance model and the current operation of the ship.

In the model, also operational conditions 11 are taken into consideration as parameters representing dynamic input data. These are in the first hand operation settings and base load for propulsion and auxiliary systems, and emission targets. Other possible operational conditions include e.g. speed data, operational mode consisting of data and instructions that define the particulars according to which the marine vessel or ship is operating, like e.g. open sea mode or port mode if these can be predicted in advance. Furthermore, the operating hours define the duration of the different operational modes and their sequences and can also be used in the model. The fuel costs give the fuel types and process to be used.

The fuel/fuel quality measurement unit 13 has information of the available fuels and their characteristics in order to find the most efficient way of operation. The information provided by the unit enables an engine to operate in an efficient way and taking the emission targets into account. The fuel consumption 12 is monitored and displayed by the fuel/fuel quality unit 13, as well as recorded as a signal into use for the optimization.

Information about forecasts 9, environmental conditions 10, operational conditions 11 and fuel information, as well as the energy consumption of various devices 5, and total energy consumption 7 are collected with sensors or instruments via the signal and data collection function unit 6 to the control unit. Also the signals of the operation and configuration of the power plant 1 are collected.

The signals describing the current behavior of the ship is used as a partial input for the simulation model 4 to be used in the continuous energy optimization 3 that tries to find a better configuration for the power plant 1.

The simulation model 4 is continuously improved by utilizing fresh information continuously collected during the operation of the ship. Thus fresh forecast information 9, information about environmental conditions 10, operational conditions 11, fuel 13, and energy production 8 are collected, which is indicated by unit 6 and fed as input for model learning, as well as for performing an optimization 3 by using the energy optimization simulation model 4.

The model 4 might also have input from the engine (not shown in the figure).The input from the engine also consists of information of emissions, whereby the emissions of the engine is input to the model in order to compare the emissions with the emissions target set by rules or the authorities and limit the amount of the emissions below the target values. The optimization can also take into account the emission targets and constraints. Input for the simulation model 4 used for the continuous energy optimization consist of both the information of the current operation parameters for the operation of the ship and conditions on board, as well as the environmental condition measurements and forecasts. Information of conditions on board is given by signals form sensors on board during the operation of the ship and indicated by unit 6. The signals are directly or through a database received by a processor and processed by the simulation model used in the system created to make use of fresh information of dynamic parameters influencing on the energy and fuel consumption.

The obtained signals represent measurement results from sensors during the operation of the ship and are used for producing a set of new dynamic input data to be used in the simulation model. A new simulation result for the ship performance is then calculated by using said produced input data in the simulation model. The simulation result is then compared with the actual ship operation that was received as the partial input as mentioned above.

If the difference between the simulation result and the actual operation exceeds defined threshold criteria, the model is improved by redefining the relationships between the distribution of the load, fuel and energy consumption, and other dynamic input data, like external factors and factors related to operation and emissions.

Said new input data is taken into consideration by the energy optimization simulation model 4 in order to make an improved prediction for the energy and fuel consumption. Said new input data as given by the sensors includes the same kind of input data that was used in creating the initial model, i.e. forecasts 9, environmental conditions 10, operational conditions 12, fuel 13 and energy production 8 and the efficiency curve and emissions from the engine. Of course some input data may not have been changed. The energy optimization model may have other inputs depending on the modification of the energy management procedure and in some embodiments all these inputs mentioned maybe are not used in the model. All variations belong to the scope of this invention.

For example, route information, schedules and forecasts can be used for evaluation future needs so to avoid turning off individual devices but these factors are not taken into consideration when the optimization is done only for a momentary power need.

The model used in the invention can be utilized in energy management by improving the current power plant configuration.

The propulsion efficiency and propulsion features and phenomena that effect on the system level efficiency are integrated and modeled in the procedure. Based on the prediction calculated by the simulation model, the energy balance management and possible load shedding are advised to the control unit to improve the power plant configuration.

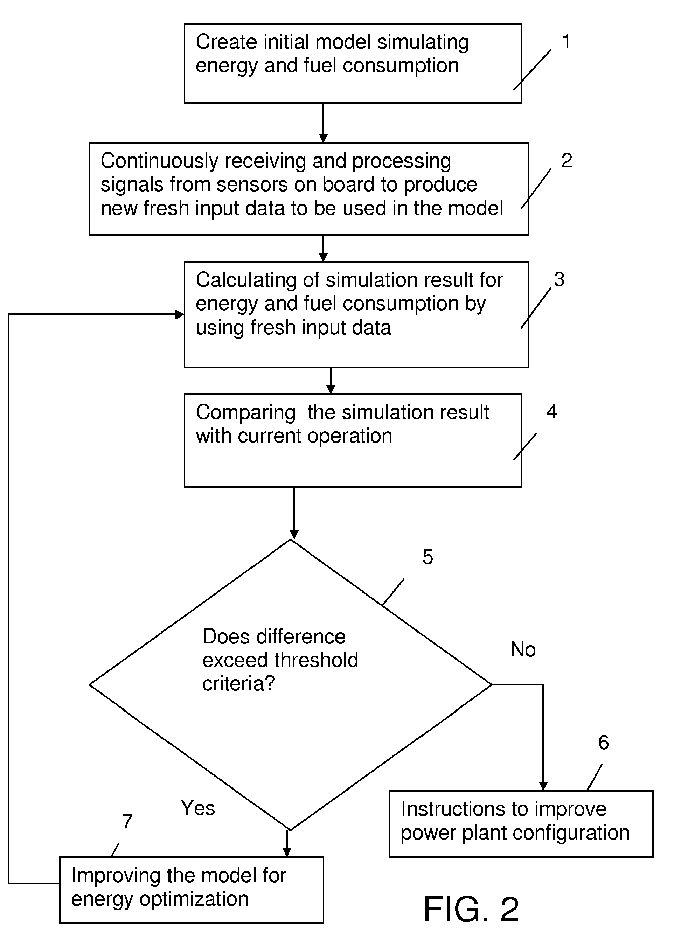

Figure 2 presents a flow scheme of the first embodiment of the invention. A model is produced that simulates energy and fuel consumption for a ship. In this embodiment, the model optimizes efficient energy and fuel consumption, and energy production.

In the first step 1, an initial model for simulating the energy and fuel consumption is created by means of relationships between factors related to the ship during operation and parameters presenting primary dynamic input data that said factors depend on. Said parameters consist of information of external conditions during the operation of the ship, operational conditions, energy production, energy consumption, fuel consumption and power plant configuration.

In step 2, measurement results are obtained from sensors during the operation of the ship for producing a set of new dynamic input data to be used in the model. The sensors measure fresh data about said parameter information that was used in step 1, continuously during operation. Fresh in this connection means results that are measured later in time than the foregoing parameter values earlier used as the dynamic input in the model.

A simulation result for the power plant performance is calculated in step 3 by using the input data produced in step 2 in said model. This means that the simulation result is achieved by using the new set of input data in said model.

The simulation result is then compared with the current ship operation in step 4 received as a partial input.

If the difference between the simulation result and the actual operation are within defined threshold criteria for quality, which is considered in step 5, the model does not need to be improved anymore and the calculation of the optimal power plant configuration as well as the instructions for improving the power plant configuration can be sent to the control unit in step 6.

Steps 3 - 5 are then repeated until defined quality criteria are met.

Certain quality criteria and constraints are set for a proper operation with respect e.g. to the total fuel consumption and the distribution of the energy between the energy production devices. Also e.g. emission targets play a role for the quality criteria and constraints.

If the difference between the simulation result and the actual operation are within defined threshold criteria for quality, which is considered in step 5, the model does not need to be improved anymore and instructions for improving the power plant configuration can be sent to the control unit in step 6.

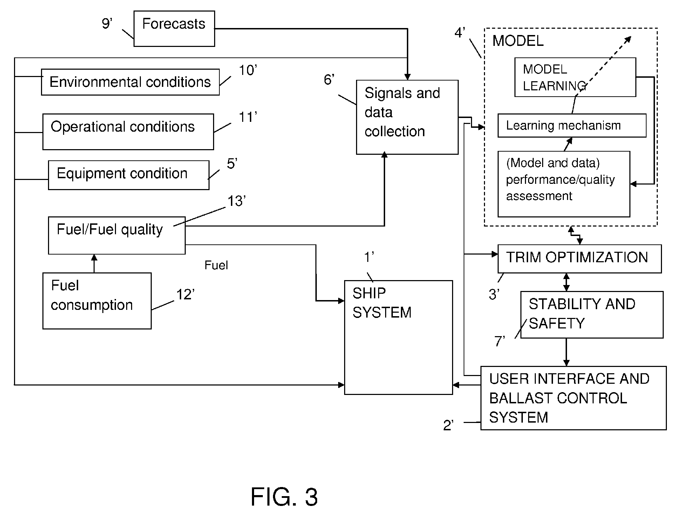

Figure 3 presents a second embodiment of the invention in the form of a block diagram. In this embodiment the invention is used for vessel floating position, such as trim optimization, whereby the model simulates the performance of the ship.

Figure 3 illustrates the interactivity between the control system of the ship, the conditions on board, and the vessel floating position. The control system includes the model for simulating the optimum vessel floating position. This means the trim, list or draft even if in the following text, for simplicity, sometimes only the trim is mentioned

Also in the second embodiment of the invention used for vessel floating position optimization, signals on board are registered. Such signals might include weather, wave, and sea current data as well as information of route and schedules. These signals describe external conditions, operational parameters like the draft, speed, use of stabilizers, equipment condition of e.g. hull, propellers and machines and factors relating to the pumping of ballast water needed to change the longitudinal inclination of the vessel, i.e. the trim. Also dynamic signals of propulsion system such as shaft power, propeller pitch, etc. are taken into account.

Route information and weather forecasts can be used either to change trim or not to change even if the current conditions should require that. This is a question of evaluation against different factors. It takes quite a long time, a couple of hours, to change the trim. Therefore it might in some circumstances be better (more optimal) to keep the current trim, e.g. when the destination is already close.

Route information and weather, current and sea state forecasts can be as additional signals helping to understand the forecoming conditions. This prevents the change of trim in situations when the current trim is close to optimal for the forecoming conditions even if the current conditions should require changing the trim. This is a question of evaluation against different factors. For a large ship it can take quite a long time, to make big adjustments in the trim, as it can require pumping several tons of ballast water. Therefore it might in some circumstances be better (more optimal) to keep the current trim, e.g. when the destination is already close, or if the current trim becomes optimal in the near-future operating conditions.

The model is trained with the collected data. The usability and quality of the collected data and information content is monitored and possible erroneous measurements are removed before training the model. There can be an initial model based on earlier knowledge that is trained or then also the initial model is based on collected data during operation.

The model is trained with a learning mechanism including a quality assessment module as indicated in the figure. When the model is ready for use, information of the current situation (real time data) is collected and an optimum trim (or an optimum draft or list) is determined by using the model for optimization and possibly changing the vessel floating position as a consequence of the optimization result. The energy needed to change the trim (not necessary) can be taken into consideration in the optimization. The trim is changed by pumping ballast water inside the vessel from bow side to aft side or vise verse, or taking in more ballast water, or pumping ballast water to the sea.

Also safety and stability limits 7' can be taken into consideration in the optimization if desired.

The optimization result is shown for the user on the user interface 2'. The user can then, based on stability and safety checks, change the floating position by using the ballast control system 2'. It is also possible to have the ballast system to change the floating position automatically.

The ballast control system 2' is connected to the ship system 1', which here is a common block just to illustrate the actions for energy production, auxiliary systems, propulsion systems, operating and maneuvering devices, moving resistance, etc. including the energy to move the ship in dynamic conditions and the energy to operate the ship internal processes in dynamic conditions.

Changing the vessel floating position changes the ship wet surface and the bow wave formation, and thus affects to the power required from the propulsion system to move the vessel at desired speed. The propulsion, auxiliaries and the electrical system affects the energy and fuel consumption and might have an influence in the optimization of the vessel floating position and information is therefore collected in a database.

Information for model improving will be transferred via a signal and data collection function unit 6' to the control unit to get all the basic data from load points to available power in order to find an optimal floating position of the vessel.

The control unit of the ship includes a model 4' for simulation of the vessel floating position, and a ballast control system 2', which controls the vessel floating position. The practical processes and procedures for the operation of the vessel floating position are performed in accordance with the instructions from the optimization by the ballast control system 2'.

There is a user interface connected to the ballast control system by means of which the optimum vessel floating position is shown if it is possible in view of the overall management. The optimization can take safety limits into consideration.

The function of vessel floating position optimization 3' is performed by a simulation model 4'. The simulation model is created on the basis of the conditions affecting the vessel floating position, the energy consumption and the use of the devices.

The current vessel floating position given by the optimization for the ballast control system is based both on forecasts 9' actual environmental conditions 10' (like weather, sea currents, wind, sea state, sea depth) and operational conditions 11' (like speed, stabilizers, rudder action, propeller pitch, RPM, shaft power, fuel consumption, and draft) as well as equipment condition 5' (hull, propeller propulsion system, engine condition).

In the model 4', also operational conditions 11' are taken into consideration as dynamic input parameters. These are in the first hand operation settings and base load for propulsion and auxiliary systems, emission targets, and constraints. Other possible operational conditions include e.g. speed data, operational mode consisting of data and instructions that define the particulars according to which the marine vessel or ship is operating, like e.g. open sea mode or port mode if these can be predicted in advance. Furthermore, the operating hours define the duration of the different operational modes and their sequences and can also be used in the model. The fuel costs give the fuel types and process to be used.

The fuel/fuel quality unit 13' has information of the available fuels and their characteristics and informs the control unit in order to find the most efficient way of operation.

Information about forecasts 9', environmental conditions 10', operational conditions 11' and fuel information is collected with sensors or instruments via the signal and data collection function unit 6' to the control unit.

The current operation of the ship is used as a partial input for the simulation model 4' to be used in the continuous trim optimization interactively connected to the model 4'. Instead of the trim, the draft or lift might be optimized.

The simulation model 4' is continuously improved by utilizing fresh information continuously collected during the operation of the ship. Thus fresh forecast information 9', information about environmental conditions 10', equipment conditions 5', operational conditions 11', fuel 5', and propulsion energy production 8' are collected, which is indicated by unit 6' and fed as input for performing an optimization function 3' by the trim optimization simulation model 4'.

The signals are received by a processor directly or via a database and processed by the simulation model used in the system created to make use of fresh information of dynamic parameters influencing on e.g. the energy consumption.

The obtained signals represent measurement results from sensors during the operation of the ship and are used for producing a set of new dynamic input data to be used in the simulation model. A simulation result for the ship performance is then calculated by using said produced input data in the simulation model. The optimized simulation result is then compared with the actual ship operation that was received as the partial input as mentioned above.

If the difference between the simulation result and the actual operation exceeds defined threshold criteria, the model is improved by redefining the relationships between the energy consumption and resistance of the vessel and dynamic input data, like external factors and factors related to operation and emissions.

Said new input data is taken into consideration by the trim optimization simulation model 4' in order to make an improved prediction. Of course some input data may not have been changed. The model may have other inputs depending on the embodiment used and in some embodiments all these inputs mentioned maybe are not used in the model. All variations belong to the scope of this invention.

For example, route information, schedules and forecasts can be used for evaluation future needs so to avoid control actions that may lead to suboptimal solution in the near-future, but these factors are not taken into consideration when the optimization is done only for a momentary power need.

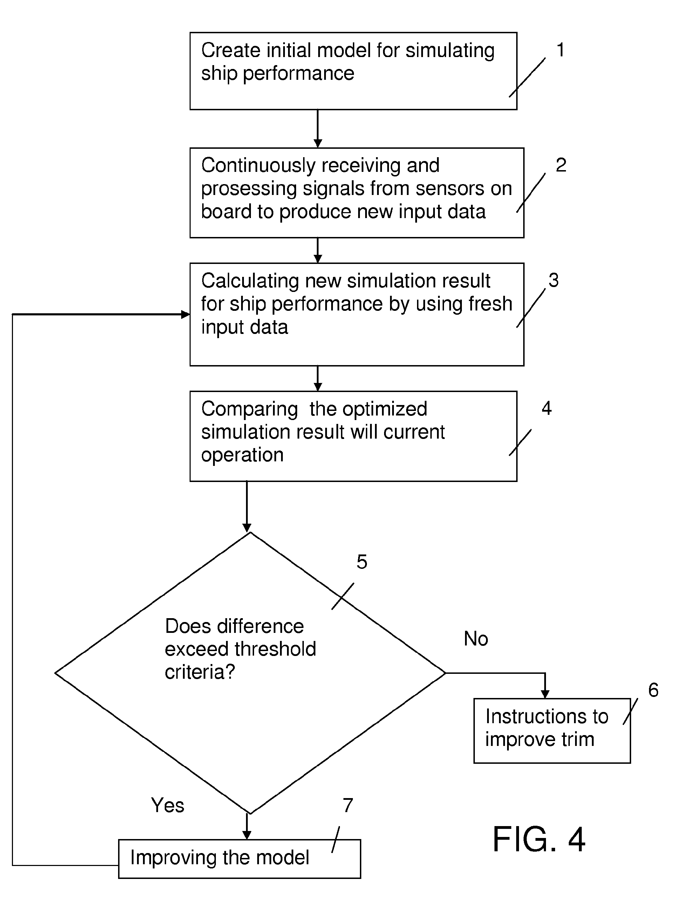

Figure 4 presents a flow scheme of the second embodiment of the invention. A model is produced that predicts operational parameters related to energy consumption, fuel consumption and energy production for a ship. In this embodiment the model optimizes the optimum trim for a ship.

In the first step 1, an initial model for simulating the ship performance is created by means of relationships between factors related to the trim of the ship and parameters presenting primary dynamic input data that depend on said factors. Said parameters consist of information of external conditions during the operation of the ship and operational conditions. The initial model can be based on earlier knowledge or it can be created on the basis of collected data during the operation of the ship.

In step 2, measurement results are obtained from sensors during the operation of the ship for producing a set of new dynamic input data to be used in the model. The sensors measure fresh data about said parameter information that was used in step 1, continuously during operation. Fresh in this connection means results that are measured later in time than the foregoing parameter values earlier used as the dynamic input in the model.

A new simulation result for ship performance is calculated in step 3 by using the input data produced in step 2 in said model. This means that the simulation result is achieved by using the new set of input data in said model in order to obtain a plurality of possible results that can be calculated with said new input data and by selecting the result that is closest to set quality criteria for the operation of the ship.

The optimized simulation result is then compared with the current ship operation in step 4 received as a partial input.

If the difference between the simulation result and the actual operation exceeds defined threshold criteria for quality, which is considered in step 5, the model is improved in step 7 by redefining the relationships between factors related to the ship during operation and parameters presenting primary dynamic input data that said factors depend on.

Steps 3 - 5 are then repeated until defined quality criteria are met.

Certain quality criteria and constraints are set for a proper operation with respect e.g. to the total fuel consumption and the distribution of the energy between the energy production devices. Also e.g. emission targets play a role for the quality criteria and constraints.

If the difference between the simulation result and the actual operation are within defined threshold criteria for quality, which is considered in step 5, the model does not need to be improved anymore and the optimal floating position is calculated and the instructions for improving the trim can be sent to the control unit in step 6.

One skilled in the art understands that the invention can be used for modeling other systems in the ship. In figures 1 - 4 there is a concrete system that is modeled and that partly is based on measurements during operation. In the second embodiment, the floating position of the ship is affected through the ballast system, which has an influence on the energy needed to move the ship. In the first embodiment the configuration of the power plant is affected, which has an influence of the fuel consumption (or emissions or other targets).

## Claims

1. A computer-implemented method to produce a model that predicts the performance of a ship, comprising the steps of
a) creating an initial model for simulating the performance of the ship by means of relationships between factors related to the ship during operation and parameters presenting primary dynamic input data that said factors depend on,
b) obtaining measurement results from sensors during the operation of the ship for producing a set of new dynamic input data to be used in the model,
c) simulating the performance of the ship by using said produced input data in said model instead of the primary dynamic input data,
d) comparing the simulation result with the actual ship operation,
e) improving the model if the difference between the simulation result and the actual operation exceeds defined threshold criteria,
f) repeating steps b) - e) until defined quality criteria are met.

2. Method of claim 1, **characterized in that** said model is used for predicting the energy balance of energy consuming devices on a ship and fuel consumption of the ship as a function of the vessel power plant configuration, whereby it simulates the performance of the vessel power plant describing the energy consumption, fuel consumption and energy production of the ship and the distribution of the load between the devices and their relationships to external and operational factors.

3. Method of claim 1, **characterized in that** said model is used for predicting the energy and fuel consumption as a function of the vessel floating position, such as the trim, draft or list of a ship, whereby it describes the relationships between the floating position, the energy and fuel consumption, and their relationships to external and operational factors.

4. Method of claim 1 and 2, **characterized by** a further step g) in which said power plant configuration is optimized by making use of new dynamic input data obtained in step b) of claim 1 when defined quality criteria are met.

5. Method of claim 1 and 3, **characterized by** a further step g) in which the vessel floating position is optimized by making use of the new dynamic input data obtained in step b) of claim 1.

6. Method of any of claims 1, 2, 3, 4, or 5, **characterized in that** said model in step e) is improved by redefining the relationships in the model in order to obtain a simulation result that is closer to said threshold criteria than the foregoing result.

7. Method of claim 1, 2, 3, 4, 5, or 6, **characterized in that** said parameters representing dynamic input data consist of information of external conditions during the operation of the ship, such as weather, wind, sea state, sea currents, sea depths, waves, ambient temperature, ambient humidity, barometric pressure, and/or seawater temperature.

8. Method of claim 1, 2, 3, 4, 5, 6 or 7, **characterized in that** said parameters representing dynamic input data consist of information of operational conditions during the operation of the ship such as operation settings of the ship equipment such as propulsion, auxiliary or maneuvering devices" base load for propulsion and auxiliary systems, emissions, constraints, speed data, operational mode, and/or fuel information.

9. Method of claim 1, 3, 5, 6, 7, or 8, **characterized in that** said parameters representing dynamic input data during operation consist of information of operational conditions and states of the ship equipment (e.g. propulsion, auxiliary and maneuvering devices) during the operation of the ship such as route and schedules, draft, speed, use of stabilizers, rudder action, RPM, draft, propeller pitch, and other equipment condition of e.g. hull, propellers and machines and factors relating to the pumping of ballast water needed to change the vessel position such as the trim.

10. Method of f claims 1, 2, 3, 4, 5, 6, 7, 8, or 9, further **characterized by** continuously monitoring and evaluation of the measurement data quality and reliability as well as the quality of the model and the modeling results, by ignoring measurements or estimating measurements to be some other value on the basis of information and dynamics from other measurements, foregoing values, and/or the relationships describing the measurements, if obtained measurements are evaluated to be erroneous.

11. A system in a ship for predicting the performance of a ship, the system comprising
a) a processor unit having a computer model
- simulating the performance of a ship,
- defining relationships between factors relating to the performance of a ship and parameters presenting dynamic input parameters that said factors depend on,
- having means for learning dependencies between the said factors and the dynamic input parameters, and having
- means for continuously obtaining measurement results during the operation of the ship and for using the measurement results for producing sets of new dynamic input parameters to be used in the model instead of input parameters used earlier in the initial model,
- means for calculating a simulation result for the ship performance by using said produced input data in said model,
- means for comparing the optimized simulation result with the actual ship operation,
- means for updating the initial model to be used as the model in further operation and further updating the model until the model meets preset quality criteria,
b) sensors signaling measurement results during the operation of the ship to the processor.

12. System of claim 11, **characterized in that** said model simulates the performance of the power plant describing the energy consumption, fuel consumption and energy production of the ship and the distribution of the load between the devices and their relationships to external and operational factors.

13. System of claim 11, **characterized in that** said model is used for predicting the fuel or energy consumption of the ship as a function of the vessel floating position, such as the trim, draft or list of a ship, whereby it describes the relationships between the floating position, the energy and fuel consumption, and their relationships to external and operational factors.

14. System of claim 11, 12 or 13, **characterized in that** the model has means for continuously monitoring and evaluation of the measurement data quality and reliability as well as the quality of the model and the modeling results, by ignoring measurements or estimating measurements to be some other value on the basis of information and dynamics from other measurements, foregoing values, and/or the relationships describing the measurements, if obtained measurements are evaluated to be erroneous.

15. Computer program product run in a processor unit in a ship, constituting of a model simulating the performance of a ship, the model defining relationships between factors relating to the performance of a ship and parameters presenting dynamic input parameters that said factors depend on, and performing the steps of
- automatically learning dependencies between said factors and the dynamic input parameters,
- continuously using sets of new dynamic input parameters in the simulation instead of input parameters used earlier, the new dynamic input parameters being produced from measurement results from sensors during the operation of the ship, and
- updating itself until it meets preset quality criteria preset quality criteria.
